# EUROPEAN PATENT APPLICATION

(11) **EP 2 592 399 A1**
(43) Date of publication of application: **15.05.2013**
(21) Application number: 11830771.9
(22) Date of filing: 07.10.2011
(51) Int. Cl.: G01J 1/42, F21S 2/00

(54) **LIGHTING ENVIRONMENT EVALUATION METHOD AND LIGHTING ENVIRONMENT EVALUATION DEVICE**

(30) Priority: 21.01.2011 JP 2011011191; 08.10.2010 JP 2010228969
(71) Applicant: Toshiba Lighting & Technology Corporation, Yokosuka-shi Kanagawa 237-8510 (JP)
(72) Inventor: NOGUCHI Yoko, Kanagawa 237-8510 (JP)
(74) Representative: Willquist, Sofia Ellinor
(86) International application number: PCT/JP2011/073208
(87) International publication number: WO 2012/046840

(57) **Abstract**

According to one embodiment, a lighting environment evaluation method includes setting a specific plane in a lighting space as an evaluation object; setting an observation set point on the specific plane; calculating, based on information relating to a reflector to reflect light in the lighting space and information relating to a luminaire provided in the lighting space, an illuminance at the observation set point based on only indirect light from the reflector and obtaining a brightness feeling index of the lighting space from a calculation result.

## Description

### Technical Field

Embodiments described herein relate generally to a lighting environment evaluation method and a lighting environment evaluation apparatus.

### Background Art

Lighting has a large influence on the comfort of an office environment and living environment. As an evaluation method of such a lighting environment, horizontal plane illuminance can be used. According to JIS (Japanese Industrial Standards), illuminance standards using the horizontal plane illuminance are regulated for indoor lighting and building industry.

In lighting design, the lighting environment evaluation method using the horizontal plane illuminance as stated above is mainly used. However, the horizontal plane illuminance represents the light flux per unit area incident on a floor or a desk, and does not represent light reaching a human eye, and the impression of a space can not be necessarily properly evaluated.

On the other hand, in recent years, an evaluation method using luminance is adopted because lighting design close to human sense can be performed. For example, Non Patent Literature 1 discloses that a human being can differentiate and perceive a feeling that a light source is high and a feeling (feeling of light quantity) that the space is full of light, and a determination factor of brightness feeling of a space is the feeling of light quantity. In Non Patent Literature 1, calculation of the feeling of light quantity using a luminance distribution is tried based on this theory.

Besides, Patent Literature 1 proposes a method in which a specific area of lighting space is set in the visual field of an observer, a luminance distribution is obtained in the specific area, a geometric average luminance is obtained after a very high luminance (light source luminance) is eliminated from the obtained luminance distribution, and the geometric average luminance is used as a brightness feeling index of the space. For example, in Patent Literature 1, a picture is taken by a digital camera, and the geometric average luminance of the specific area can be obtained by obtaining the luminance distribution of the photographed image.

However, although the geometric average luminance can be calculated for an existing space by taking a picture, if a luminance distribution image can not be photographed as in an indoor space before completion, a simulation based on luminous intensity distribution data is required to be performed. The simulation based on the luminous intensity distribution data is a work using computer graphic software and requiring time and labor, and the luminance distribution of the specific area can be not easily obtained.
Patent Literature 1
   JP-A-2007-171055
Non Patent Literature 1
   "Psychological Determinants of Brightness of a Space - Perceived Strength of Light Source and Amount of Light in the Space-", Taiichiro ISHIDA, et al., Journal of the Illuminating Engineering Institute of Japan, Vol. 84, No. 8A, pp. 473-479 (2000)

### Summary of Invention

### Technical Problem

Embodiments of the invention have an object of providing a lighting environment evaluation method and a lighting environment evaluation apparatus, in which brightness feeling of space can be easily evaluated by using an illuminance at a point on a vertical plane in the space.

### Solution to Problem

According to one embodiment, a lighting environment evaluation method includes setting a specific plane in a lighting space as an evaluation object, setting an observation set point on the specific plane, calculating, based on information relating to a reflector to reflect light in the lighting space and information relating to a luminaire provided in the lighting space, an illuminance at the observation set point based on only indirect light from the reflector and making a calculation result a brightness feeling index of the lighting space.

### Brief Description of Drawings

FIG. 1 is a block diagram showing a lighting environment evaluation apparatus of a first embodiment of the invention.
FIG. 2 is an explanatory view for explaining setting of a light information setting part 11 of the embodiment.
FIG. 3 is a flowchart for explaining a method of obtaining an evaluation value of brightness feeling.
FIG. 4 is a flowchart for explaining another method of obtaining an evaluation value of brightness feeling.
FIG. 5 is an explanatory view showing an evaluation scale of subjective evaluation.
FIG. 6 is a graph showing a relation between horizontal plane illuminance and brightness feeling evaluation, in which the horizontal axis indicates the horizontal plane illuminance obtained at an experiment and the vertical axis indicates the brightness feeling evaluation value of an experimental result.
FIG. 7 is a graph showing a relation between illuminance at eye including direct light and brightness feeling evaluation, in which the horizontal axis indicates the illuminance at the eye based on direct light and indirect light and the vertical axis indicates the brightness feeling evaluation value of an experimental result.
FIG. 8 is a graph showing a relation between illuminance at eye based on only indirect light and brightness feeling evaluation, in which the horizontal axis indicates the illuminance at the eye based on only indirect light and the vertical axis indicates the brightness feeling evaluation value of an experimental result.
FIG. 9 is a flowchart showing a second embodiment of the invention.
FIG. 10 is an explanatory view showing a distribution of illuminance at eye.
FIG. 11 is a block diagram showing a third embodiment of the invention.
FIG. 12 is a flowchart showing the third embodiment.
FIG. 13 is an explanatory view for explaining spaces different from each other in lighting conditions.
FIG. 14 is an explanatory view showing a display example by an information output part 13.
FIG. 15 is a flowchart showing an operation flow corresponding to the flowchart of FIG. 4 in the third embodiment.
FIG. 16 is a graph showing a relation between illuminance at eye based on only indirect light and brightness feeling evaluation, in which the horizontal axis indicates the illuminance at the eye based on only indirect light and the vertical axis indicates the brightness feeling evaluation value of an experimental result.
FIG. 17 is an explanatory view for explaining another setting of the light information setting part 11.
FIG. 18 is a graph showing a relation between an illuminance at eye based on only indirect light at an observation set point, which is set on a specific plane 28' of FIG. 17, and a brightness feeling evaluation value.

### Description of Embodiments

Hereinafter, embodiments of the invention will be described in detail with reference to the drawings.

According to one embodiment, a lighting environment evaluation method includes setting a specific plane in a lighting space as an evaluation object, setting an observation set point on the specific plane, calculating, based on information relating to a reflector to reflect light in the lighting space and information relating to a luminaire provided in the lighting space, an illuminance at the observation set point based on only indirect light from the reflector and obtaining a brightness feeling index of the lighting space from a calculation result.

Besides, the obtaining the brightness feeling index includes calculating a first illuminance at the observation measurement point based on direct light among light from the luminaire and the indirect light from the reflector, calculating a second illuminance at the observation measurement point based on the direct light among the light from the luminaire, and calculating the illuminance at the observation set point based on calculation results of the first and the second illuminances and based on only the indirect light from the reflector.

Besides, the lighting environment evaluation method of the embodiment further includes obtaining a distribution of brightness feeling in the lighting space by using illuminances based on only the indirect light from the reflector, which are obtained with respect to at least plural observation set points on plural specific planes different from each other in normal line direction or plural observation set points at different positions.

Besides, the lighting environment evaluation method of the embodiment includes calculating an illuminance based on only direct light among light from the luminaire, calculating the illuminance based on only the indirect light from the reflector among the light from the luminaire, and outputting information of the illuminance based on only the direct light and the illuminance based on only the indirect light.

Besides, the lighting environment evaluation method of the embodiment further includes calculating an illuminance based on only direct light among light from the luminaire, calculating the illuminance based on only the indirect light from the reflector among the light from the luminaire, calculating a ratio between the illuminance based on only the direct light and the illuminance based on only the indirect light, and outputting information of the ratio between the illuminances.

Besides, in the lighting environment evaluation method of the embodiment, the specific plane is a vertical plane.

Besides, a lighting environment evaluation apparatus of the embodiment uses the above lighting environment evaluation method to evaluate brightness feeling in the lighting space.

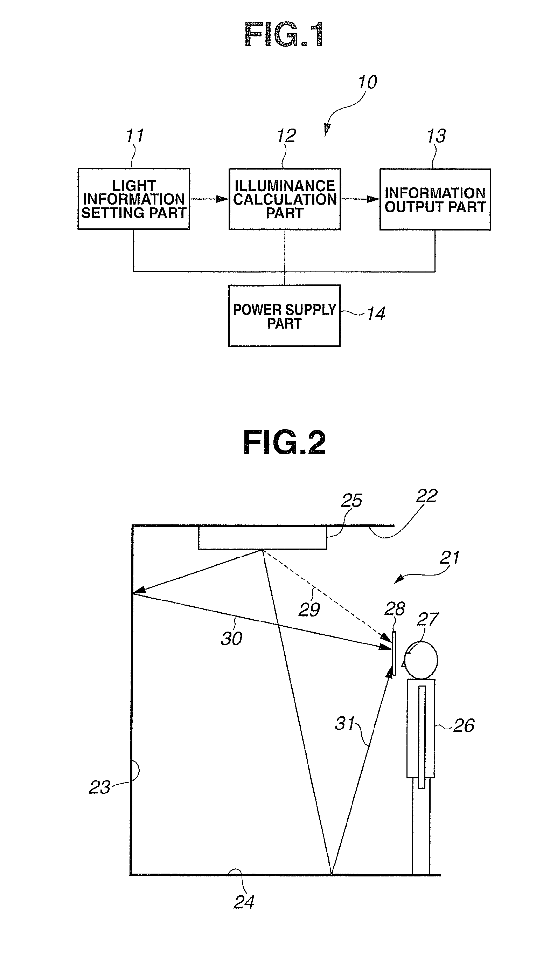

FIG. 1 is a block diagram showing a lighting environment evaluation apparatus of a first embodiment of the invention.

A lighting environment evaluation apparatus 10 includes a light information setting part 11. The light information setting part 11 sets an environment relating to lighting in a lighting space as an evaluation object. The light information setting part 11 supplies information of the set environment relating to the lighting to an illuminance calculation part 12. The illuminance calculation part 12 calculates an illuminance based on the information from the light information setting part 11.

In this embodiment, the light information setting part 11 performs setting such that a specific vertical plane is assumed in the lighting space as the evaluation object, and light incident on a specific position in the vertical plane is obtained. The specific vertical plane and a point (hereinafter referred to as an observation set point) in the vertical plane are set according to an eye direction (line-of-sight direction) and a position of a person assumed in the lighting space as the evaluation object.

The illuminance calculation part 12 calculates an illuminance (hereinafter referred to also as an illuminance at eye) at the observation set point in the vertical plane, and outputs a calculation result as information representing a brightness feeling in the lighting space as the evaluation object. That is, in this embodiment, light reaching an eye is represented by the illuminance at the observation set point in the vertical plane, which is assumed to be the eye position. The information output part 13 can present the information representing the brightness feeling, which is calculated by the illuminance calculation part 12, as a brightness feeling index to a user. For example, a liquid crystal display or a speaker can be adopted as the information output part 13. Incidentally, a power supply part 14 supplies power to the respective parts.

FIG. 2 is an explanatory view for explaining the setting of the light information setting part 11 in this embodiment.

A lighting space 21 as an evaluation object is an indoor space surrounded by a ceiling 22, a wall 23 and a floor 24. A luminaire 25 is placed on the ceiling 22. A person 26 stands on the floor 24. In this embodiment, a vertical plane 28 is assumed to be positioned in front of an eye 27 of the person 26. The vertical plane 28 is arranged vertically to a line-of-sight direction of the eye 27 of the person 26.

A direct light 29 (broken line) from the luminaire 25, an indirect light 30 from the wall 23, an indirect light 31 from the floor 24 and the like are incident on the vertical plane 28. The illuminance calculation part 12 obtains the brightness feeling in the lighting space based on the illuminance of the light incident on the observation set point of the vertical plane 28. Further, the illuminance calculation part 12 can obtain the brightness feeling in the lighting space more accurately by obtaining the illuminance by using only the indirect light other than the direct light 29 among the lights incident on the vertical plane 28.

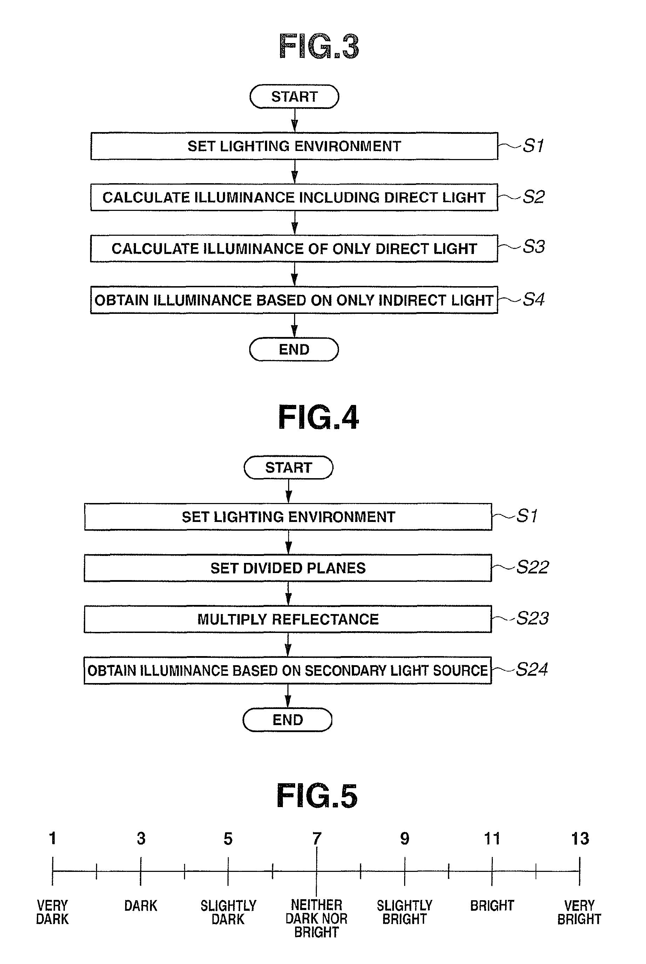

FIG. 3 is a flowchart for explaining a method of obtaining an evaluation value of brightness feeling.

At step S1, the light information setting part 11 sets, as environmental information relating to lighting, the number and positions of luminaires to be arranged, data of luminous intensity distribution characteristics of the luminaires, the position, size, reflectance and the like of a reflecting surface of a material body (hereinafter referred to as a reflector including the ceiling, wall, floor and the like) to reflect light, such as the ceiling, the wall and the floor, which constitute the space, and an installed object to be arranged in the space.

A point corresponding to the eye in the vertical plane is made the observation set point, and the illuminance calculation part 12 sets a reflectance according to an attribute of the reflecting surface of the reflector, and calculates the illuminance at the observation set point (step S2). The illuminance calculation part 12 adopts, for example, a well-known method and can perform illuminance calculation.

The illuminance obtained at step S2 by the illuminance calculation part 12 is the illuminance (hereinafter referred to also as the illuminance at the eye including direct light) obtained by the irradiation of the direct light and the indirect light to the observation set point. In this embodiment, in order to improve the evaluation accuracy of the brightness feeling, the influence of the direct light is eliminated. That is, at step S3, the reflectance of the reflecting surface of the reflector is assumed to be 0% irrespective of the attribute, and the illuminance calculation part 12 performs the illuminance calculation. Accordingly, in the illuminance calculation at step S3, only the illuminance based on the direct light is obtained.

At step S4, the illuminance calculation part 12 subtracts the illuminance value calculated at step S3 from the illuminance value calculated at step S2. In this way, the illuminance calculation part 12 obtains the illuminance (hereinafter referred to also as the illuminance at the eye based on only indirect light) at the observation set point based on the indirect light.

FIG. 4 is a flowchart for explaining another method of obtaining an evaluation value of brightness feeling. In FIG. 4, the same procedure as that of FIG. 3 is denoted by the same reference sign and its description is omitted.

At step S22, the illuminance calculation part 12 virtually divides the reflecting surface of the reflector. Next, the illuminance calculation part 12 multiplies a direct light flux received by each of the divided surfaces from the luminaire by the reflectance of each of the divided surfaces (step S23). The illuminance calculation part 12 regards the divided surface as a secondary light source to disperse the light flux with the value obtained at step S23, and calculates the illuminance formed at the observation set point by the respective secondary light sources (step S24). The illuminance obtained at step S24 is the illuminance at the eye based on only indirect light.

Next, based on an experiment, a description will be made on that the illuminance at the eye calculated by the illuminance calculation part 12 is valid as an index representing brightness feeling in a lighting space.

In this experiment, while a lighting condition in an indoor space is changed, ten subjects perform subjective evaluation, and the validity of the index is examined. In the indoor space where the experiment was performed, eight luminaires were arranged on the ceiling, two wall side luminaires and seven buried luminaires were arranged on one wall, and thirteen lighting conditions in total were set by changing the lighting and extinction of these luminaires and by performing dimming so that horizontal plane illuminances of a desk arranged in the indoor space became different values.

FIG. 5 is an explanatory view showing an evaluation scale of the subjective evaluation. The subjects perform evaluation in accordance with the evaluation scale of FIG. 5 in the lighting environments under the respective lighting conditions, and each of them determines an evaluation point (personal point). In the example of FIG. 5, thirteen stages are provided from a feeling of being very dark to a feeling of being very bright, and the subject gives marks of one point to thirteen points according to the brightness impression. The personal points of all the subjects are averaged for each of the lighting conditions, and the brightness feeling evaluation value under each of the lighting conditions is obtained.

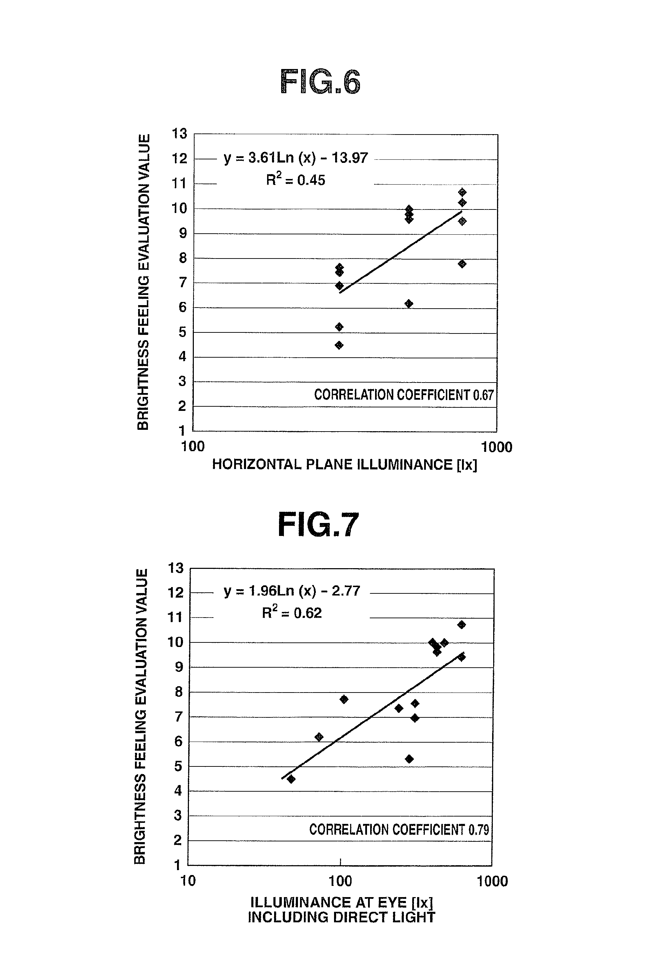

FIG. 6 to FIG. 8 are for explaining the experimental results, and respective plot points of FIG. 6 to FIG. 8 indicate values under the respective lighting conditions. FIG. 6 to FIG. 8 respectively show a relation between a horizontal plane illuminance and a brightness feeling evaluation value, a relation between an illuminance at eye including direct light and a brightness feeling evaluation value, and a relation between an illuminance at eye based on only indirect light and a brightness feeling evaluation value. All the illuminances are indicated by a logarithmic axis.

FIG. 6 is a graph showing the relation between the horizontal plane illuminance and the brightness feeling evaluation, in which the horizontal axis indicates the horizontal plane illuminance obtained in the experiment and the vertical axis indicates the brightness feeling evaluation value of the experimental result. From the distribution of FIG. 6, it is found out that the variation of the brightness feeling evaluation value is large with respect to the horizontal plane illuminance. That is, it is found out that the horizontal plane illuminance can not necessarily be a valid brightness feeling evaluation index. Incidentally, FIG. 6 shows an example in which the straight line represents a regression expression expressed by y = 3.61Ln(x)-13.97, a determination coefficient R2 is 0.45 and a correlation coefficient is 0.67.

FIG. 7 is a graph showing the relation between the illuminance at the eye including direct light and the brightness feeling evaluation, in which the horizontal axis indicates the illuminance at the eye based on direct light and indirect light and the vertical axis indicates the brightness feeling evaluation value of the experimental result. From the distribution of FIG. 7, it is found out that the variation of the brightness feeling evaluation value is relatively small with respect to the illuminance at the eye including direct light. That is, it is found out that the illuminance at the eye based on direct light and indirect light in this embodiment can be a valid brightness feeling evaluation index. Incidentally, FIG. 7 shows an example in which the straight line represents a regression expression expressed by y = 1.96Ln(x)-2.77, a determination coefficient R2 is 0.62 and a correlation coefficient is 0.79.

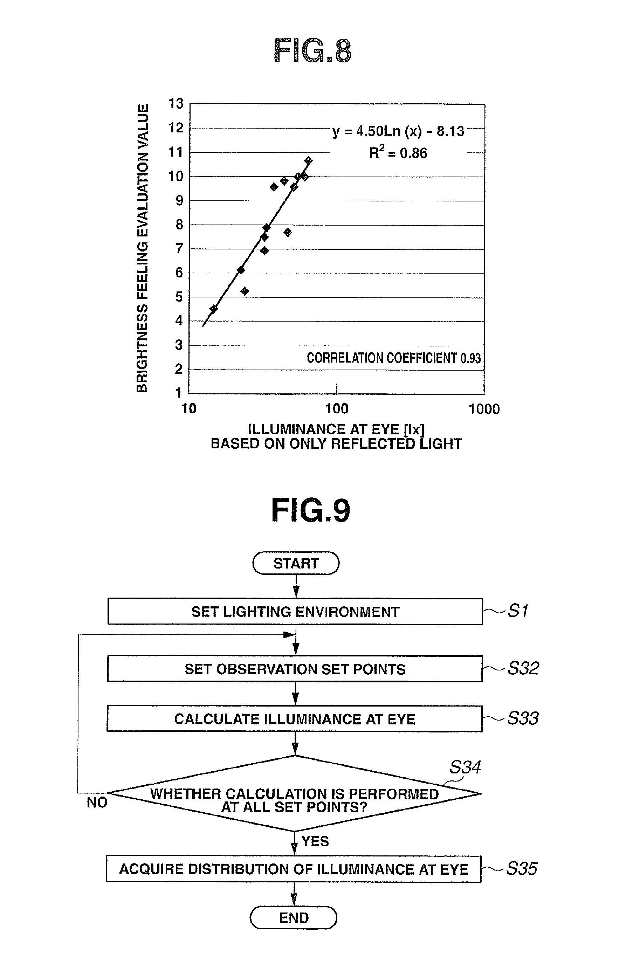

FIG. 8 is a graph showing the relation between the illuminance at the eye based on only indirect light and the brightness feeling evaluation, in which the horizontal axis indicates the illuminance at the eye based on only indirect light and the vertical axis indicates the brightness feeling evaluation value of the experimental result. From the distribution of FIG. 8, it is found out that the variation of the brightness feeling evaluation value is sufficiently small with respect to the illuminance at the eye based on only indirect light. That is, it is found out that the illuminance at the eye based on only indirect light in this embodiment can be a much valid brightness feeling evaluation index. Incidentally, FIG. 8 shows an example in which the straight line represents a regression expression expressed by y = 4.50Ln(x)-8.13, a determination coefficient R2 is 0.86 and a correlation coefficient is 0.93.

As described above, in this embodiment, the vertical plane is set in the lighting space as the evaluation object, the illuminance at the eye based on only indirect light other than direct light at the observation set point on the vertical plane is obtained, and this value is made the brightness feeling evaluation index.

In Patent Literature 1 and Non Patent Literature 1, the brightness feeling evaluation index is regulated by using the geometric average luminance obtained from the luminance distribution. However, the calculation of the luminance distribution requires observation of light from all points in the space at all the points in the space, and enormous calculation is required. On the other hand, in this embodiment, the illuminance at the eye is used as the brightness feeling evaluation index, and the time, labor and cost for performing simulation to obtain the luminance distribution are reduced, and the much valid brightness feeling evaluation index can be calculated in the same number of steps as those of the case of obtaining the horizontal plane illuminance and by the simple calculation.

FIG. 9 is a flowchart showing a second embodiment of the invention. In FIG. 9, the same procedure as that of FIG. 3 is denoted by the same reference sign and its description is omitted. The hardware structure of this embodiment is the same as that of the first embodiment.

In the first embodiment, one vertical plane is set in the lighting space as the evaluation object, and the illuminance at one observation set point in the vertical plane is obtained as the illuminance at the eye and is made the brightness feeling index. On the other hand, in this embodiment, plural illuminances at the eye in the lighting space as the evaluation object are used as the brightness feeling evaluation index. For example, plural vertical planes are set in the lighting space, and the illuminance at one observation set point in each of the vertical planes is obtained as the illuminance at the eye. Besides, each of illuminances at plural observation set points in one vertical plane in the lighting space may be obtained as the illuminance at the eye. Besides, even at the same point in the lighting space, the illuminance at the eye varies according to the normal line direction of the vertical plane. That is, when the normal line direction of the vertical plane varies, the observation set point varies even at the same point in the lighting space. Plural illuminances at the eye may be obtained in the respective normal line directions of the vertical plane at the same position.

At step S32 of FIG. 9, the illuminance calculation part 12 sets an observation set point on one vertical plane in the lighting space. Next, the illuminance calculation part 12 calculates the illuminance at the eye at the set observation set point. As a calculation method of the illuminance at the eye, for example, the method shown in FIG. 3 and FIG. 4 can be adopted.

Next, at step S34, the illuminance calculation part 12 determines whether the illuminances at the eye at all the observation set points are calculated. If the illuminances at the eye at all the observation set points are not calculated, the process is returned to step S32, an observation set point different from the former is set, and the process is repeated.

The illuminance calculation part 12 calculates the illuminances at the eye at all the observation set points, and obtains the distribution of the illuminance at the eye at step S35.

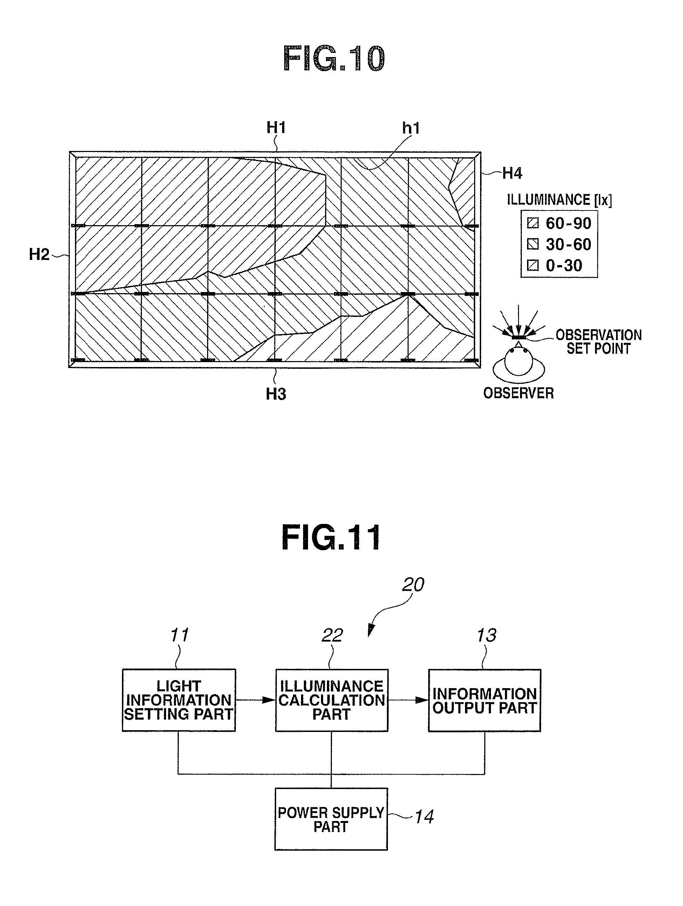

FIG. 10 is an explanatory view showing the distribution of the illuminance at the eye based on only indirect light. FIG. 10 shows a plane of a lighting space which is 6 m wide, 4 m deep and 3 m high and is surrounded by a ceiling, a floor and walls H1 to H4. Vertical planes are indicated by filled-in portions. Incidentally, as shown in FIG. 10, the vertical planes are set correspondingly to the line of sight of the observer. The line-of-sight direction at the observation set point, which is set in each of the vertical planes, is set to a direction perpendicular to a wall surface h1 of the wall H1 and directed to the wall surface h1, and the height is fixed to 1.5 m from the floor surface. The observation set points are arranged at 21 places at intervals of 1 m, so that they are planarly arranged at equal intervals in the lighting space.

The illuminance calculation part 12 obtains the illuminances at the eye based on only indirect light at all the set observation set points, connects observation set points where the same illuminance value is obtained, and obtains the distribution of the illuminance at the eye based on only indirect light. When the number of the observation set points is small as in the example of FIG. 10, the distribution of the illuminance at the eye based on only indirect light may be obtained by obtaining illuminances at the eye based on only indirect light between the respective observation set points by interpolation. It is conceivable that the larger the number of the observation set points is, the more accurately the distribution of the illuminance at the eye is obtained. However, the number may be freely increased or decreased in view of the balance with respect to the calculation time.

In the example of FIG. 10, a portion of positive slope lines with narrow intervals indicates a range where the illuminance at the eye is 60-90 [lx], a portion of negative slope lines with narrow intervals indicates a range where the illuminance at the eye is 30-60 [lx], and a portion of positive slope lines with wide intervals indicates a range where the illuminance at the eye is 0-30 [lx].

The brightness feeling in the lighting space can be easily grasped by the distribution of the illuminance at the eye based on only indirect light in FIG. 10. In the example of FIG. 10, when the observation is performed in the direction toward the wall surface h1, it is found out that the brightness feeling is high at a position close to the wall surface h1, and the brightness feeling is low at a position remote from the wall surface h1.

As stated above, in this embodiment, there are merits that the valid brightness feeling index can be obtained by the simple illuminance calculation, and the distribution state of the brightness feeling in the lighting space can be grasped by obtaining the distribution of the illuminance at the eye based on only indirect light.

In Patent Literature 1, although the luminance distribution is obtained under the assumption of calculation of the brightness feeling index, finally, the geometric average of the obtained luminance distribution is made the brightness feeling index, and the brightness feeling of the lighting space is evaluated by only one numerical value. On the other hand, in this embodiment, the distribution of the illuminance at the eye of the lighting space is acquired by the simple calculation, and the index, which sufficiently reflects the brightness feeling of the space changing according to the position and direction of the observer even in the same space, can be obtained.

FIG. 11 is a block diagram showing a third embodiment of the invention. In FIG. 11, the same component as that of FIG. 1 is denoted by the same reference sign and its description is omitted.

An illuminance calculation part 22 has the same structure as the illuminance calculation part 12, and obtains an evaluation value of brightness feeling by the same method as the illuminance calculation part 12. For example, the illuminance calculation part 22 obtains an illuminance at eye including direct light, an illuminance based on direct light, and an illuminance at eye based on only indirect light by the procedure of steps S2 to S4 of FIG. 3.

In this embodiment, the illuminance calculation part 22 calculates the ratio between the illuminance based on direct light and the illuminance at the eye based on only indirect light among the illuminance at the eye including direct light. The illuminance calculation part 22 outputs the information of the illuminance at the eye including direct light, the illuminance based on direct light, the illuminance at the eye based on only indirect light and the ratio to an information output part 13.

The information output part 13 presents the information of the illuminance at the eye including direct light, the illuminance based on direct light, the illuminance at the eye based on only indirect light and the ratio, which is given from the illuminance calculation part 22, to the user.

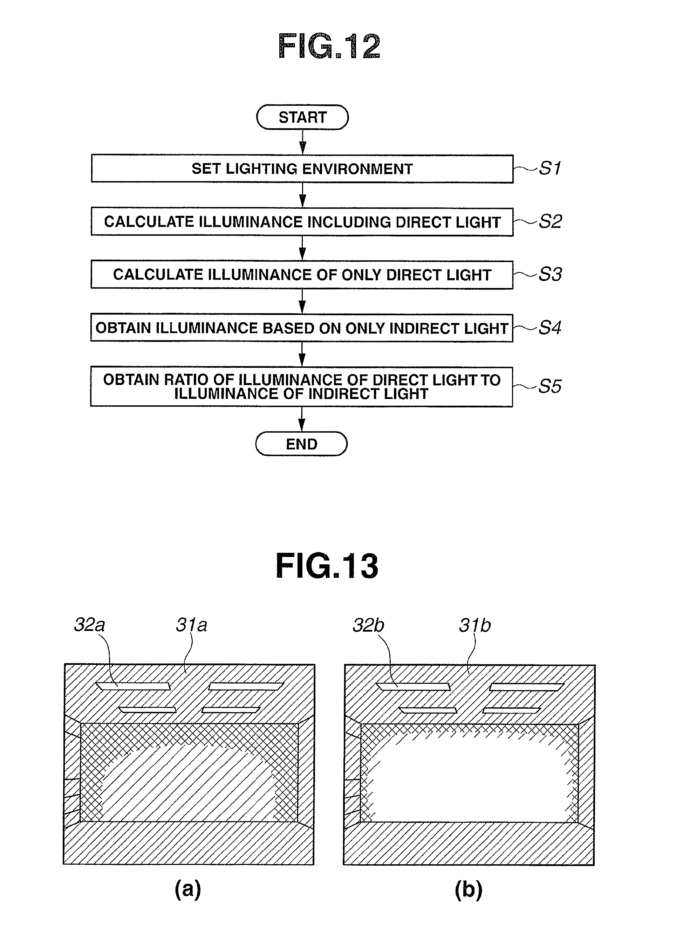

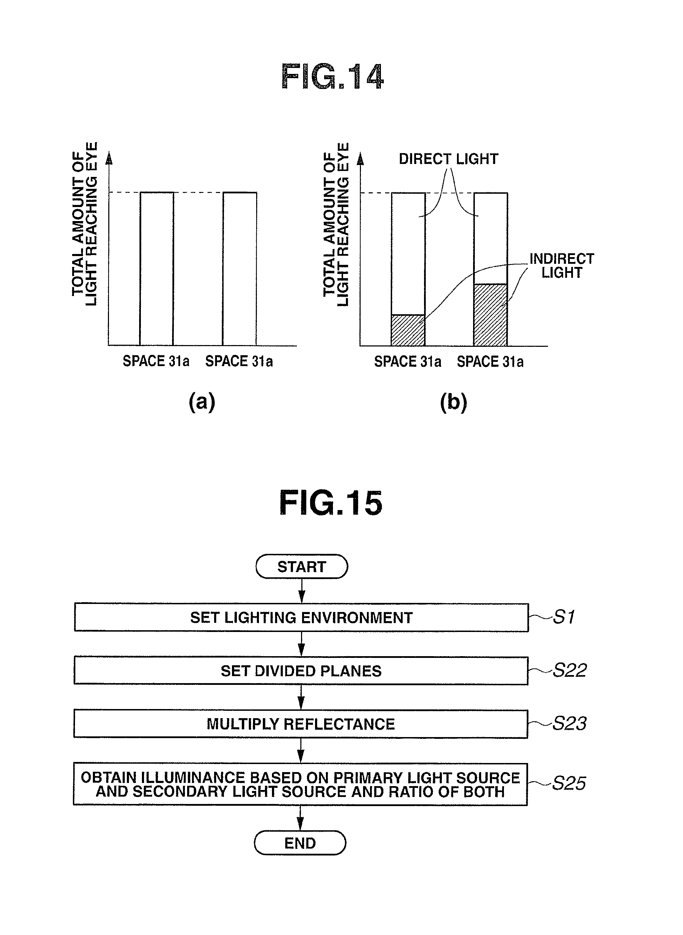

Next, an operation of the embodiment constructed as described above will be described with reference to FIG. 12 to FIG. 14. FIG. 12 is a flowchart showing the third embodiment. In FIG. 12, the same procedure as that of FIG. 3 is denoted by the same reference sign and its description is omitted. Besides, FIG. 13 is an explanatory view for explaining spaces different from each other in lighting conditions. FIG. 14 is an explanatory view showing a display example by the information output part 13.

FIGs. 13(a) and 13 (b) show identical spaces 31a and 31b photographed under different lighting conditions, and show photographed images obtained by photographing identical photographing ranges by a not-shown identical camera arranged at identical positions of the identical spaces 31a and 31b and directed in identical directions.

The spaces 31a and 31b are indoor spaces surrounded by walls in four directions, a lighting lamp 32a is placed on a ceiling of the space 31a, and a lighting lamp 32b is placed on a ceiling of the space 31b. The spaces 31a and 31b are illuminated by the lighting lamps 32a and 32b under different lighting conditions.

However, vertical plane illuminances E1 and E2 at the lens position of the camera are set so as to become an equal value of 300 [lx]. In the related art lighting calculation apparatus, only the vertical plane illuminances E1 and E2 are displayed, and it is interpreted that there is no difference in brightness impression of the spaces 31a and 31b according to only the values obtained by the related art lighting calculation apparatus.

However, actually, as shown in FIGs. 13(a) and 13(b), from the difference of the luminance distribution on the back wall, the brightness impression is different between the space 31a and the space 31b, and it is felt that the brightness feeling of the space 31b is higher than that of the space 31a.

Then, in this embodiment, the illuminance calculation part 22 obtains the ratio between the illuminance based on direct light and the illuminance at the eye based on only indirect light. That is, at steps S1 to S4 of FIG. 12, the illuminance calculation part 22 obtains the illuminance at the eye including direct light, the illuminance based on direct light, and the illuminance at the eye based on only indirect light. Further, at step S5, the illuminance calculation part 22 obtains the ratio between the illuminances of direct light and indirect light.

Now, it is assumed that as a result of the calculation by the illuminance calculation part 22, in the space 31a, the illuminance based on direct light is 240 [lx], and the illuminance at the eye based on only indirect light is 60 [lx]. In this case, the illuminance calculation part 22 calculates that the ratio of the illuminance based on direct light is 80 [%] and the ratio of the illuminance at the eye based on only indirect light is 20[%].

Besides, it is assumed that as a result of the calculation by the illuminance calculation part 22, in the space 31b, the illuminance based on direct light is 180 [lx], and the illuminance at the eye based on only indirect light is 120 [lx] . In this case, the illuminance calculation part 22 calculates that the ratio of the illuminance based on direct light is 60 [%], and the ratio of the illuminance at the eye based on only indirect light is 40 [%].

The illuminance calculation part 22 outputs the calculation results to the information output part 13. The information output part 13 displays the calculation results of the illuminance calculation part 22 on a display. For example, the information output part 13 displays the photographed images of FIGs. 13 (a) and 13 (b), and displays the calculation results as in Table 1 below correspondingly to the photographed images.

**Table 1**

| | SPACE 31a | SPACE 31b |
|---|---|---|
| VERTICAL PLANE ILLUMINANCE | E1=300 [lx] | E2=300 [lx] |
| ILLUMINANCE BASED ON DIRECT LIGHT | 240 [lx] (80%) | 180 [lx] (600) |
| ILLUMINANCE AT EYE BASED ON ONLY INDIRECT LIGHT | 60 [lx] (200) | 120 [lx] (400) |

Besides, as shown in FIG. 14, the information output part 13 may display the calculation results of the illuminance calculation part 22 by graph display. FIG. 14 (a) shows a display based on the vertical plane illuminance. In FIG. 14 (a), the total amount of light reaching the eye is the same between the space 31a and the space 31b.

On the other hand, FIG. 14 (b) shows an example in which display is performed so that the ratio between the illuminance based on direct light and the illuminance at the eye based on only indirect light becomes clear. An oblique line portion of FIG. 14(b) indicates the illuminance at the eye based on only indirect light. According to the display of FIG. 14(b), the ratio between the illuminance based on direct light and the illuminance at the eye based on only indirect light is intuitively easily grasped.

The user compares the illuminances based on direct light shown in above-described Table 1 and in FIG. 14(b), and can recognize that the intensity feeling of the light source of the space 31a is higher than that of the space 31b. Besides, the user compares the illuminances at the eye based on only indirect light shown in Table 1 and FIG. 14(b), and can recognize that the feeling of light quantity of the space 31b is higher than that of the space 31a. Besides, since the brightness feeling of the space is influenced by the feeling of light quantity, it is conceivable that the brightness feeling of the space 31b is higher than that of the space 31a. Besides, comparative evaluation of various conditions is easily performed by displaying the ratio between the illuminance based on direct light and the illuminance at the eye based on only indirect light.

Incidentally, the information output part 13 may display only the illuminance based on direct light and the illuminance at the eye based on only indirect light, or may display only the ratio between these illuminances.

As stated above, in this embodiment, the illuminance based on direct light and the illuminance at the eye based on only indirect light are separately presented and the ratio between both can be presented. The user can easily grasp the degree of the intensity feeling of the light source at that point and the feeling of light quantity, and can consider the impression of the lighting environment in more detail.

Incidentally, in the above embodiment, although the example is described in which the illuminance based on direct light, the illuminance at the eye based on only indirect light and the ratio between both are obtained by the same flow as FIG. 3, these values can be obtained by the same flow as FIG. 4.

FIG. 15 is a flowchart for explaining the operation of this case. In FIG. 15, the same procedure as FIG. 4 is denoted by the same reference sign and its description is omitted.

When the flow of FIG. 15 is adopted, at step S22, the illuminance calculation part 22 virtually divides the outgoing surface of a light source and the reflecting surface of a reflector. Next, with respect to the reflector, the illuminance calculation part 22 multiplies a direct light flux from a luminaire, which is received by each of the divided surfaces, by the reflectance of each of the divided surfaces (step S23).

At step S25, the illuminance calculation part 22 regards the divided surfaces of the light source as primary light sources, and regards the divided surfaces of the reflector as secondary light sources to emit the light flux having the value obtained at step S23, and calculates illuminances formed on the observation set point by the respective primary light sources and the secondary light sources. The illuminance by the respective primary light sources is the illuminance based on direct light, and the illuminance by the respective secondary light sources is the illuminance at the eye based on only indirect light. The illuminance calculation part 22 obtains the ratio between the calculated illuminance based on direct light and the illuminance at the eye based on only indirect light.

The other operation is the same as the case where the flow of FIG. 12 is adopted. Besides, the third embodiment can also be applied to the second embodiment.

In the above respective embodiments, it is described that the illuminance at the eye, particularly the illuminance at the eye based on only indirect light is much valid as the index representing the brightness feeling in the lighting space. The experimental results of FIG. 6 to FIG. 8 prove the validity. It is conceivable that the illuminance at the eye obtained in the above respective embodiments, particularly the illuminance at the eye based on only indirect light can be the valid index expressing the brightness feeling in the lighting space irrespective of the kind of the light source (luminaire) .

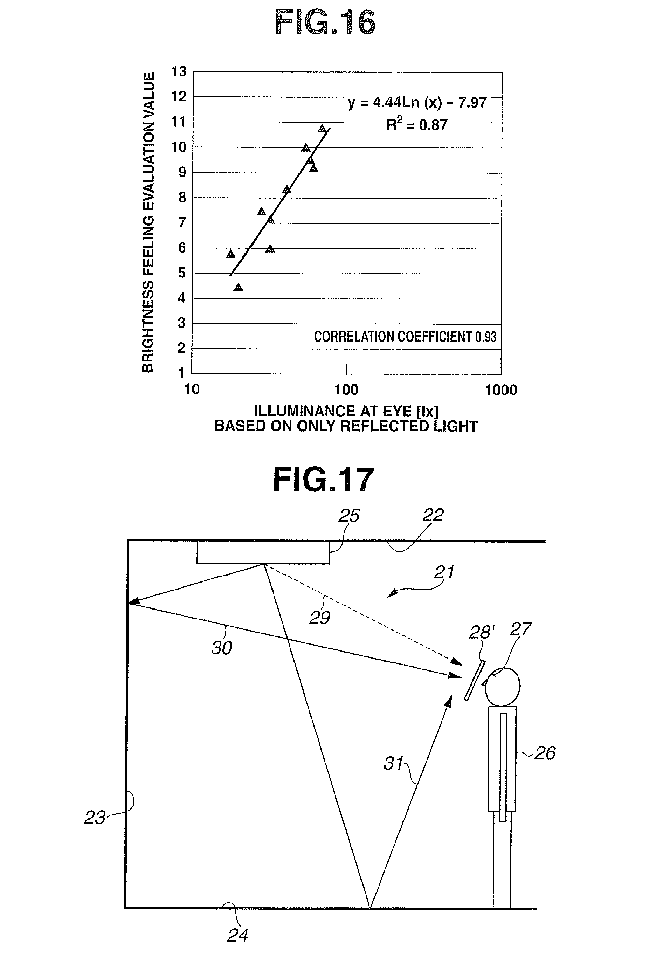

FIG. 16 is for explaining that the validity is obtained irrespective of the kind of the light source. That is, FIG. 16 is a graph showing experimental results obtained by performing the same experiment as the experiment shown in FIG. 6 to FIG. 8. That is, in the indoor space where the experiment was performed, eight luminaires were arranged on the ceiling, two wall side luminaires and seven buried luminaires were arranged on one wall, and ten lighting conditions in total were set by changing the lighting and extinction of the luminaires and by performing dimming so that horizontal plane illuminances of a desk arranged in the indoor space became different values. While the lighting conditions in the indoor space are changed, ten subjects perform subjective evaluation, and the validity of the index is examined.

In the experiments shown in FIG. 6 to FIG. 8, although fluorescent lamps are used as all the luminaires, in the experiment shown in FIG. 16, LEDs are adopted as all the luminaires, and the number of the lighting conditions is ten. The other experimental environment is identical to each other. Besides, the evaluation scale of subjective evaluation shown in FIG. 5 is adopted also in FIG. 16. The evaluation is performed in accordance with the evaluation scale of FIG. 5, and the brightness feeling evaluation value under each of the lighting conditions is obtained by averaging the personal points of all the subjects for each of the lighting conditions.

FIG. 16 shows a relation between the illuminance at the eye based on only indirect light and the brightness feeling evaluation, in which the horizontal axis indicates the illuminance at the eye based on only indirect light and the vertical axis indicates the brightness feeling evaluation value of the experimental result. Respective plot points of FIG. 16 indicate values under the respective lighting conditions. FIG. 16 shows the relation between the illuminance at the eye based on only indirect light and the brightness feeling evaluation value, and all the illuminances are indicated by a logarithmic axis.

From the distribution of FIG. 16, also when the LED lighting is adopted, it is found out that the variation of the brightness feeling evaluation value is sufficiently small with respect to the illuminance at the eye based on only indirect light. That is, it is found out that the illuminance at the eye based on only indirect light obtained in the above embodiment can be a much valid index as the brightness feeling evaluation also in the case of the LED lighting.

Besides, FIG. 16 shows the example in which the straight line indicates a regression expression expressed by y = 4.44Ln(x)-7.97, a determination coefficient R2 is 0.87, and a correlation coefficient is 0.93. That is, the straight line shown in FIG. 8 and the straight line shown in FIG. 16 are very similar to each other. By this, it is found out that the illuminance at the eye based on only indirect light obtained in the above embodiment is the brightness feeling evaluation index which can be used commonly in the same scale irrespective of whether the luminaire is the fluorescent lamp or the LED.

Besides, in the above respective embodiments, the specific vertical plane is set and the illuminance at the eye at the observation set point on the vertical plane is obtained. The vertical plane is set because the line-of-sight direction when the person stands erectly is assumed. When the line-of-sight direction not horizontal is assumed as in a case where the person looks up or down, for example, the observation set point is preferably set on a plane inclined from the vertical direction according to the face of the person.

FIG. 17 is an explanatory view for explaining setting of the light information setting part 11 (see FIG. 1) in this case. FIG. 17 is different from FIG. 2 only in that a specific plane 28' is set as a plane assumed to be positioned in front of an eye 27 of a person 26 instead of the vertical plane 28. The specific plane 28' is the plane orthogonal to the line-of-sight direction of the eye 27 of the person 26.

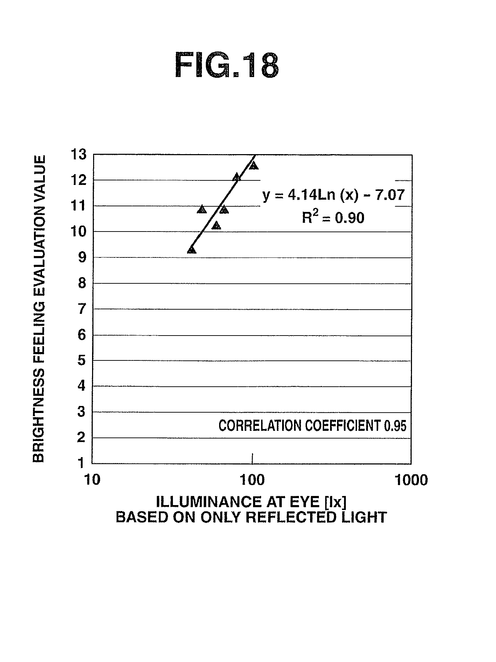

FIG. 18 is a graph showing a relation between the illuminance at the eye based on only indirect light at an observation set point which is set on the specific plane 28' of FIG. 17 and the brightness feeling evaluation value, which is obtained by the same experiment as the experiment shown in FIG. 16. Incidentally, the specific plane 28' is set to have an elevation angle of 25 degrees. From the distribution of FIG. 18, it is found out that also when the observation set point is set not on the vertical plane but on the specific angle inclined plane, the variation of the brightness feeling evaluation value is sufficiently small with respect to the illuminance at the eye based on only indirect light. That is, it is found out that the illuminance at the eye based on only indirect light obtained in the above embodiment can be a much valid index as brightness feeling evaluation irrespective of the angle (elevation angle) of the specific plane on which the observation set point is provided.

Incidentally, FIG. 18 shows an example in which the straight line indicates a regression expression expressed by y = 4.14Ln(x)-7.07, a determination coefficient R2 is 0.90, and a correlation coefficient is 0.95.

This application is based upon and claims the benefit of priority from Japanese Patent Application No. 2010-228969 filed on October 8, 2010 and Japanese Patent Application No. 2011-11191 filed on January 21, 2011, the entire contents of which are incorporated in the present specification, the claims and the drawings by reference.

## Claims

1. A lighting environment evaluation method comprising:
setting a specific plane in a lighting space as an evaluation object;
setting an observation set point on the specific plane;
calculating, based on information relating to a reflector to reflect light in the lighting space and information relating to a luminaire provided in the lighting space, an illuminance at the observation set point based on only indirect light from the reflector and obtaining a brightness feeling index of the lighting space from a calculation result.

2. The lighting environment evaluation method according to claim 1, wherein the obtaining the brightness feeling index includes
calculating a first illuminance at the observation measurement point based on direct light among light from the luminaire and the indirect light from the reflector,
calculating a second illuminance at the observation measurement point based on the direct light among the light from the luminaire, and
calculating the illuminance at the observation set point based on calculation results of the first and the second illuminances and based on only the indirect light from the reflector.

3. The lighting environment evaluation method according to claim 1 or 2, further comprising obtaining a distribution of brightness feeling in the lighting space by using illuminances based on only the indirect light from the reflector, which are obtained with respect to at least a plurality of observation set points on a plurality of specific planes different from each other in normal line direction or a plurality of observation set points at different positions.

4. The lighting environment evaluation method according to claim 1, further comprising:
calculating an illuminance based on only direct light among light from the luminaire;
calculating the illuminance based on only the indirect light from the reflector among the light from the luminaire; and
outputting information of the illuminance based on only the direct light and the illuminance based on only the indirect light.

5. The lighting environment evaluation method according to claim 1, further comprising:
calculating an illuminance based on only direct light among light from the luminaire;
calculating the illuminance based on only the indirect light from the reflector among the light from the luminaire;
calculating a ratio between the illuminance based on only the direct light and the illuminance based on only the indirect light; and
outputting information of the ratio between the illuminances.

6. The lighting environment evaluation method according to any one of claims 1 to 5, wherein the specific plane is a vertical plane.

7. A lighting environment evaluation apparatus using the lighting environment evaluation method according to any one of claims 1 to 6 to evaluate brightness feeling in the lighting space.
